(19) Europäisches Patentamt
European Patent Office
Office européen des brevets

(11) **EP 2 869 335 A1**

(12) **EUROPEAN PATENT APPLICATION**
published in accordance with Art. 153(4) EPC

(43) Date of publication:
**06.05.2015 Bulletin 2015/19**

(21) Application number: **13809563.3**

(22) Date of filing: **11.04.2013**

(51) Int Cl.:
*H01L 21/368* (2006.01)   *C01G 9/00* (2006.01)
*H01L 21/20* (2006.01)   *H01L 31/04* (2014.01)

(86) International application number:
**PCT/JP2013/060905**

(87) International publication number:
**WO 2014/002574 (03.01.2014 Gazette 2014/01)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **29.06.2012 JP 2012147030**

(71) Applicant: **TOYOTA JIDOSHA KABUSHIKI KAISHA**
**Toyota-shi, Aichi-ken, 471-8571 (JP)**

(72) Inventors:
• **MAEKAWA, Ryosuke**
**Toyota-shi, Aichi-ken 471-8571 (JP)**

• **AWANO, Hiroki**
**Toyota-shi, Aichi-ken 471-8571 (JP)**
• **MATSUNAGA, Tomoya**
**Toyota-shi, Aichi-ken 471-8571 (JP)**
• **TAKEDA, Yuichiro**
**Toyota-shi, Aichi-ken 471-8571 (JP)**
• **SAKAI, Takenobu**
**Toyota-shi, Aichi-ken 471-8571 (JP)**
• **KUSANO, Yuya**
**Toyota-shi, Aichi-ken 471-8571 (JP)**

(74) Representative: **Kuhnen & Wacker**
**Patent- und Rechtsanwaltsbüro**
**Prinz-Ludwig-Straße 40A**
**85354 Freising (DE)**

(54) **SEMICONDUCTOR FILM MANUFACTURING METHOD**

(57)    An object of the present invention is to provide a method for manufacturing a semiconductor film capable of manufacturing a ZnMgO film in which the adding amount of Mg to Zn is more than 20 mol%, by means of a liquid phase deposition method. The present invention is a method for manufacturing a semiconductor film including a first step of preparing a mixture liquid including zinc hydroxide, magnesium hydroxide, and a liquid, a second step of applying a member to be film-deposited to the mixed liquid, and a third step of heating the member to be film-deposited to which the mixed liquid is applied, having a temperature range from 300°C to 400°C for 100/30 minutes or less.

Fig. 1

**Description**

BACKGROUND OF THE INVENTION

Field of the Invention

The present invention relates to a method for manufacturing a semiconductor film.

Description of the Related Art

A solar cell has advantages that the volume of carbon dioxide emissions per electric generation amount is small and it is not necessary to use fuel for electric generation. Therefore, the solar cell has been expected as an energy source to inhibit global warming. Among solar cells practically used, a mono-junction solar cell having a pair of p-n junction and employing a single crystal silicon or a polycrystalline silicon has become mainstream. However, the light absorption rate of the mono-junction solar cell is low, whereby the theoretical limit of the photoelectric conversion efficiency thereof is low. Therefore, studies related to solar cells capable of improving the light absorption rate and the theoretical limit of the photoelectric conversion efficiency have been actively conducted.

A compound thin film solar cell is one of the solar cells capable of improving the light absorption rate and the theoretical limit of the photoelectric conversion efficiency. The compound thin film solar cell saves resources, is easy to be mass produced, and has a possibility of largely improving the conversion efficiency. Recently, as a material for a buffer layer and a light emitting device for the compound thin film solar cell, $Zn_{(1-x)}Mg_xO$ ($0<x<1$. Hereinafter $Zn_{(1-x)}Mg_xO$ is sometimes referred to as "ZnMgO".) has been focused on. ZnMgO is conventionally manufactured by means of a vapor phase deposition method employing a sputtering method and the like, and the band gap of ZnMgO has been increased by increasing adding amount of Mg. However, apparatuses for the vapor phase deposition method are expensive, and it is difficult to fully cover a substrate having concavity and convexity by means of the vapor phase deposition method, since raw materials flow to one direction. A liquid phase deposition method can solve these problems, thus it is considered that ZnMgO is desirably manufactured by the liquid phase deposition method.

As a technique related to a solar cell prepared with ZnMgO, for example Patent Document 1 discloses a manufacturing method of a solar cell including a step of forming a layer containing Zn, Mg, and O, by means of a sputtering method. Also, for example Non-Patent Document 1 discloses that ZnMgo thin film is manufactured by means of a sol-gel method.

Citation List

Patent Literatures

Patent Document 1: Japanese Patent Application Laid-Open (JP-A) No. 2004-304175

Non-Patent Literatures

Non-Patent Document 1: Nanotechnology, 2011, Vol. 22, issue No. 42, p.425706

SUMMARY OF THE INVENTION

Problems to be Solved by Invention

In a case where ZnMgO is used for the compound thin film solar cell such as a CIGS solar cell, in order to have a configuration in which electrons can transfer to a p layer side in forming a p-n junction interface and a configuration in which electrons generated due to light absorption can transfer to an electrode, it is required to make the adding amount of Mg to Zn more than 20 mol% (make x as x>0.2). According to the technique disclosed in Patent Document 1, it can be considered that a ZnMgO film in which the adding amount of Mg to Zn is more than 20 mol% can be formed. However, since this technique employs a vapor phase disposition method to form the ZnMgO film, apparatuses to use are expensive and it is difficult to form a ZnMgO film which fully covers a substrate having concavity and convexity. These problems can be solved by the technique disclosed in Non-Patent Document 1 in which a ZnMgO film is formed by means of a liquid phase disposition method. However, if the ZnMgO film in which the adding amount of Mg to Zn is increased is tried to be formed by means of the conventional liquid phase disposition method as disclosed in Non-Patent Document 1, a phase-isolated MgO phase is easy to be formed together with a ZnMgO phase. Therefore, with the technique disclosed in Non-Patent Document 1, it is difficult to manufacture the ZnMgO film in which the adding amount of Mg to Zn is more than 20 mol%.

Accordingly, an object of the present invention is to provide a method for manufacturing a semiconductor film capable of manufacturing a ZnMgO film in which the adding amount of Mg to Zn is more than 20 mol%, by means of a liquid phase deposition method.

Means for Solving the Problems

The inventors of the present invention have found out the following points as a result of an intensive study. The present invention has been made based on these findings.

(1) When the ZnMgO film is formed by means of the liquid phase disposition method, by making the ratio of Mg included in the raw materials (more specifically, when the amount of Zn in the raw materials is defined as X [mol] and the amount of Mg in the raw materials is defined as Y [mol], the value of Y/(X+Y). The same is applied hereinafter) large, the adding amount of Mg to Zn (hereinafter sometimes referred to as "Mg solid solution amount") becomes easy to be increased.

(2) In an equilibrium state, the Mg solid solution amount to ZnO is kept around 4 mol%. Since the liquid phase disposition method is a process closer to the equilibrium state than the vapor phase disposition method, when the ZnMgO film is formed by means of the same method as the conventional liquid phase disposition method except that the ratio of Mg in the raw materials is increased, the maximum value of the adding amount of Mg to Zn is easy to be kept at 20 mol% or less.

(3) If the ZnMgO film is produced by means of the same method as the conventional method except that the ratio of Mg in the raw materials is increased, in order to make the adding amount of Mg to Zn more than 20 mol%, an MgO phase is easy to be formed together with a ZnMgO phase.

(4) In order to manufacture the ZnMgO film in which the adding amount of Mg to Zn is increased by means of the liquid phase disposition method, it is effective to introduce a non-equilibrium process.

(5) It is possible to inhibit the formation of an MgO phase (phase isolation of MgO) by: producing a precursor film including zinc hydroxide and magnesium hydroxide; thereafter rapidly heating to fire the precursor film so that the precursor goes through in a short time the temperature range in which the precursor film is cyristallized. Whereby, it is possible to manufacture the ZnMgO film in which the adding amount of Mg to Zn is increased more than 20 mol%.

In order to solve the above problems, the present invention takes the following means. That is, a first aspect of the present invention is a method for manufacturing a semiconductor film, the method including: a first step of preparing a mixed liquid including zinc hydroxide, magnesium hydroxide, and a liquid; a second step of applying the mixed liquid to a member to be film-deposited; and a third step of heating the member to be film-deposited to which the mixed liquid is applied, having a temperature range from 300°C to 400°C for 100/30 minutes or less.

In the first aspect of the present invention and other aspects of the present invention shown below, the precursor film including zinc hydroxide and magnesium hydroxide is applied to the member to be film-deposited which is to be heated in the third step after the second step. A producing method of the precursor film is not particularly limited as long as zinc hydroxide and magnesium hydroxide are dispersed in the precursor film. The precursor film can be produced by means of a liquid phase deposition method such as Chemical Bath Deposition (CBD) method and a sol-gel method for example. It is possible to inhibit a phase isolation of MgO by heating the precursor film having a temperature range from 300°C to 400°C which includes the temperature range in which the precursor film is crystallized for 100/30 minutes or less. As a result, it is possible to manufacture the ZnMgO film in which the adding amount of Mg to Zn is more than 20 mol%.

Also, in the first aspect of the present invention, in the third step, it is preferable to heat the member to be film-deposited having a temperature range from 300°C to 400°C for 100/36 minutes or less. This configuration makes it possible to manufacture the ZnMgO film in which the adding amount of Mg to Zn is 30 mol% or more.

A second aspect of the preset invention is a method for manufacturing a semiconductor film, the method including: a first step of preparing a mixed liquid including zinc hydroxide, magnesium hydroxide, and a liquid; a second step of applying the mixed liquid to a member to be film-deposited; and a third step of heating the member to be film-deposited to which the mixed liquid is applied so that an average temperature rising rate from 300 °C to 400°C is 30°C/min or more.

Here, "an average temperature rising rate from 300°C to 400°C is 30°C/min or more" means that, defining the time when the temperature of the precursor film is 300°C as T1 and the time when the temperature of the precursor film is 400°C as T2, the temperature rising rate from the time T1 to the time T2 is 30°C/min or more. For example, in a case where the required time for the temperature to reach from 300°C to 400°C is 10/3 minutes, the average temperature rising rate from 300°C to 400°C is 30°C/min. By heating the precursor film so that the average temperature rising rate from 300°C to 400°C including the temperature range in which the precursor film is crystallized is 30°C/min or more, it becomes possible to inhibit a phase isolation of MgO. As a result, it becomes possible to manufacture the ZnMgO film in which the adding amount of Mg to Zn is more than 20 mol%.

Also, in the second aspect of the present invention, in the third step, it is preferable to heat the member to be film-deposited to which the mixed liquid is applied so that the average temperature rising rate from 300°C to 400°C is 36°C/min or more. This configuration makes it possible to manufacture the ZnMgO film in which the adding amount of Mg to Zn is 30 mol% or more.

Also, in the first aspect or the second aspect of the present invention, it is preferable that the boiling temperature of the liquid is less than 300°C. This configuration makes it easy to manufacture the ZnMgO film in which the adding amount of Mg to Zn is more than 20 mol%.

Also, in the first aspect or the second aspect of the present invention, in the first step, determining the amount of Zn included in the raw material as X [mol] and the amount of Mg included in the raw material as Y [mol], it is preferable to produce the mixed liquid with a raw material satisfying $Y/(X+Y) > 0.4$. This configuration makes it easy to manufacture the ZnMgO film in which the adding amount of Mg to Zn is more than 20 mol%.

Effects of the Invention

According to the present invention, it is possible to provide a method for manufacturing a semiconductor film, capable of manufacturing a ZnMgO film in which the adding amount of Mg to Zn is more than 20 mol% by means of a liquid phase disposition method.

BRIEF DESCRIPTION OF THE DRAWINGS

Fig. 1 is a flowchart to explain a method for manufacturing a semiconductor film of the present invention;
Fig. 2 includes schematic views to explain the method for manufacturing a semiconductor film of the present invention and a conventional method for manufacturing a ZnMgO film:
Fig. 2A is a schematic view to explain the method for manufacturing a semiconductor film of the present invention;
Fig. 2B is a schematic view to explain the conventional method for manufacturing a ZnMgO film;
Fig. 3 is a view to show measurement results of light-absorption coefficient;
Fig. 4 is a view to show a relationship between: the temperature rising rate; and the band gap and Mg solid solution amount;
Fig. 5 is a view to show results of X-ray diffraction measurement;
Fig. 6 is a view to show a relationship between: ratios of Mg included in the raw material; and the band gap and Mg solid solution amount.

DETAILED DESCRIPTION OF THE INVENTION

Modes for Carrying Out the Invention

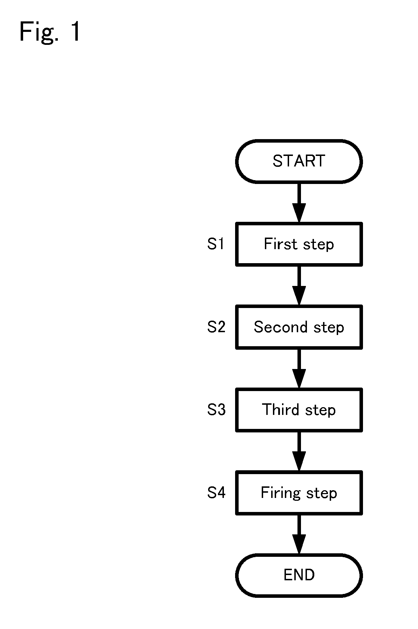

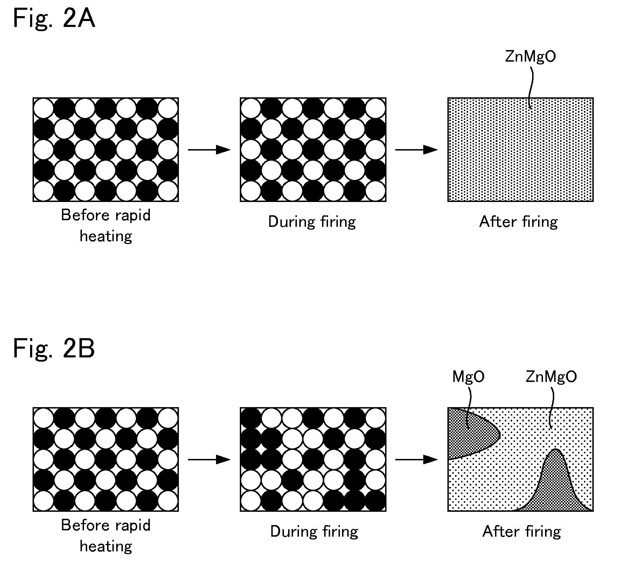

Fig. 1 is a flowchart to explain a method (hereinafter sometimes referred to "the manufacturing method of the present invention" for short) for manufacturing a semiconductor film of the present invention. Also, Fig. 2 includes schematic views to explain methods for manufacturing a semiconductor film (ZnMgO film). Fig. 2A is a schematic view to explain the manufacturing method of the present invention, and Fig. 2B is a schematic view to explain a conventional manufacturing method of a ZnMgO film. In Fig. 2, "○" indicates $Zn(OH)_2$ and "●" indicates $Mg(OH)_2$. Hereinafter the manufacturing method of the present invention will be explained with reference to Figs. 1 and 2.

As shown in Fig. 1, the manufacturing method of the present invention includes a first step (S1), a second step (S2), a third step (S3) and a firing step (S4).

The first step (hereinafter sometimes referred to as "S1") is a step of preparing a mixed liquid including zinc hydroxide ($Zn(OH)_2$), magnesium hydroxide ($Mg(OH)_2$), and a liquid. The configuration of S1 is not particularly limited as long as the mixed liquid including $Zn(OH)_2$, $Mg(OH)_2$, and a liquid can be prepared. In a case where the precursor film to be heated in the third step which is described later is produced by means of a CBD method, S1 may be, for example, a step of: putting a Zn source and an Mg source in a container in which an ammonia aqueous solution is contained; thereafter increasing the temperature of the ammonia aqueous solution to a temperature at which $Zn(OH)_2$ and $Mg(OH)_2$ precipitate. By increasing the temperature of the ammonia aqueous solution, it becomes possible to lower the pH of the ammonia aqueous solution by vaporizing ammonia, whereby it becomes possible to change the state of the ammonia aqueous solution in which $Zn(OH)_2$ precipitates. Also, by increasing the temperature of the ammonia aqueous solution, it becomes possible to change the state of the ammonia aqueous solution in which $Mg(OH)_2$ precip-

itates.

The second step (hereinafter sometimes referred to as "S2") is a step of applying the mixed liquid produced in S1 to the member to be film-deposited. S2 can be a step of putting the member to be film-deposited (hereinafter sometimes referred to as "substrate") in a container which contains the mixed liquid produced in S1 and holding the substrate for a predetermined time, to thereby apply the mixed liquid to the substrate. After applying the mixed liquid to the substrate in S2, taking out the substrate (the substrate with precipitated $Zn(OH)_2$ and precipitated $Mg(OH)_2$ on the surface thereof) from the container containing the mixed liquid, followed by drying, a precursor film including dispersed $Zn(OH)_2$ and $Mg(OH)_2$ can be produced on the surface of the substrate.

The third step (hereinafter sometimes referred to as "S3") is a step of heating the precursor film having a temperature range from 300°C to 400°C which includes the temperature range in which $Zn(OH)_2$ and $Mg(OH)_2$ included in the precursor film produced by going through the above steps are crystallized, for 100/30 minutes or less. In other words, S3 is a step of heating the precursor film so that the average temperature rising rate from 300°C to 400°C is 30°C/min or more. By heating the precursor film with this configuration, as shown in Fig. 2A, it is possible to crystallize inside of the precursor film before a lot of $Zn(OH)_2$ and $Mg(OH)_2$ transfer, whereby it is possible to obtain a ZnMgO film in which 20 mol% or more of Mg to Zn is added. In contrast, as shown in Fig. 2B, if the precursor film is heated taking a longer time than 100/30 min from 300°C to 400°C which includes the temperature range in which $Zn(OH)_2$ and $Mg(OH)_2$ included in the produced precursor film are crystallized (heated such that the average temperature rising rate becomes less than 30°C/min) as in the conventional method, while the precursor film is heated, it is easy for a lot of $Zn(OH)_2$ and $Mg(OH)_2$ to move inside the precursor film, whereby an MgO phase isolated from the ZnMgO phase tends to be formed after firing. If the MgO phase is formed as described above, since it becomes difficult to have a large amount of Mg into solid solution to the ZnMgO phase, it tends to be difficult to make the adding amount of Mg to Zn more than 20 mol%. Therefore, in order to refuse this situation, the precursor film is rapidly heated from 300°C to 400°C.

The firing step (hereinafter sometimes referred to as "S4") is a step of firing the precursor film rapidly heated in S3 at a predetermined temperature. The firing temperature in S4 is not particularly limited as long as the temperature is higher than the maximum temperature of the temperature range in which $Zn(OH)_2$ and $Mg(OH)_2$ are crystallized. The firing time in S4 is not particularly limited as long as a crystallized ZnMgO film can be produced. For example, S4 can be a step of firing the precursor film at 500°C for 1 hour.

According to the manufacturing method of the present invention including S1 to S3, since it is possible to inhibit a phase isolation of MgO by introducing a non-equilibrium process in S3, it is possible to manufacture the ZnMgO film in which the adding amount of Mg to Zn is more than 20 mol%.

In the manufacturing method of the present invention, the configuration of Zn source and Mg source contained in the raw material employed for producing the precursor film is not particularly limited. As the Zn source and Mg source, for example, acetates thereof, chlorides, nitrates, hydrosulfates and the like can be adequately employed.

Also, in the manufacturing method of the present invention, the liquid to be employed for producing the mixed liquid is not particularly limited as long as the ZnMgO film in which the adding amount of Mg to Zn is more than 20 mol% can be manufactured. However, in view of having a configuration in which the ZnMgO film as above is easy to be manufactured, preferably the liquid has a boiling temperature of less than 300°C.

Also, in the manufacturing method of the present invention, the compounding ratio of the Zn source and the Mg source contained in the raw material employed for producing the mixed liquid in S1 is not particularly limited. However, in view of having a configuration in which the ZnMgO in which the adding amount of Mg to Zn is more than 20 mol% is easy to be manufactured, defining Zn contained in the raw material as X [mol] and Mg contained in the raw material as Y [mol], preferably $Y/(X+Y)>0.4$.

Also, in the manufacturing method of the present invention, S3 is not limited as long as S3 is a step of heating the precursor film having a temperature range from 300°C to 400°C for 100/30 minutes or less (heating the film so that the average temperature rising rate is 30°C/min or more). However, in view of having a configuration in which the ZnMgO film in which the adding amount of Mg to Zn is 30 mol% or more is easy to be manufactured, it is preferable that S3 is a step of heating the precursor film having a temperature range from 300°C to 400°C for 100/36 minutes or less (heating the film so that the average temperature rising rate is 36°C/min or more).

Also, in the manufacturing method of the present invention, the substrate employed in S2 is not particularly limited as long as the substrate is capable of bearing the firing temperature in S4 and capable of forming a ZnMgO film on the surface thereof. As the substance which can configure the substrate, a quarts glass, stainless steel substrate, soda lime glass substrate and the like can be exemplified.

Also, in the manufacturing method of the present invention, the temperature of the ammonia aqueous solution to be increased in S1 is not particularly limited as long as $Zn(OH)_2$ and $Mg(OH)_2$ can be precipitated at the temperature. In order to precipitate $Zn(OH)_2$ and $Mg(OH)_2$, the temperature of the ammonia aqueous solution is preferably 30°C or more for example. Also, in view of having a configuration in which a large variation in ion concentration and depletion of the solution can be prevented, the temperature of the ammonia aqueous solution is preferably 80°C or less for example. The temperature of the ammonia aqueous solution is more preferably 40°C or more and 60°C or less.

Also, the configuration of S1 is not particularly limited as long as the mixed liquid containing $Zn(OH)_2$, $Mg(OH)_2$, and a liquid can be prepared. However, in view of having a configuration in which $Zn(OH)_2$ and $Mg(OH)_2$ are easy to be precipitated and the like, it is preferable to have a configuration in which the temperature of the stirred ammonia aqueous solution is increased so that $Zn(OH)_2$ and $Mg(OH)_2$ precipitate.

Examples

<Manufacturing of Film>

Water in an amount of 175 ml and 25 ml of 10% ammonia aqueous solution were put in a beaker. On the other hand, a Zn source (zinc acetate) and an Mg source (magnesium acetate) were weighed so that the molar ratio of zinc acetate and magnesium acetate was 1:1, and put in the beaker. Thereafter, a rotor was put in the beaker and the contents of the beaker were stirred well on a stirrer, whereby zinc acetate and magnesium acetate were dissolved. After zinc acetate and magnesium acetated were dissolved, a quarts glass substrate was put in the beaker. Then, while stirring the ammonia aqueous solution, the beaker was bathed in a water bath heated at 60°C and allowed to left for 30 minutes. Thereafter, the quarts glass substrate was taken out and dried at 200°C for 1 hour, whereby a precursor film was produced by means of a CBD method. Next, the produced precursor film was rapidly heated so that the average temperature rising rate from 300°C to 400°C was 4°C/min, 16°C/min, 30°C/min, 36°C/min, 50°C/min, or 60°C/min, thereafter fired at 500°C for 1 hour. Controlling of the average temperature rising rate was carried out by controlling the temperature of the substrate. More specifically, setting the substrate temperature at the start of the heating up as 200°C and the substrate temperature at the end of the heating up as 500°C, and by changing the required time for the substrate temperature to reach 500°C from 200°C, the average temperature rising rate from 300°C to 400°C was controlled to be 4°C/min, 16°C/min, 30°C/min, 36°C/min, 50°C/min, or 60°C/min. By going through the above steps, a ZnMgO film was manufactured. The manufactured ZnMgO film was thereafter cooled in a furnace and taken out for evaluation.

<Film Evaluation>

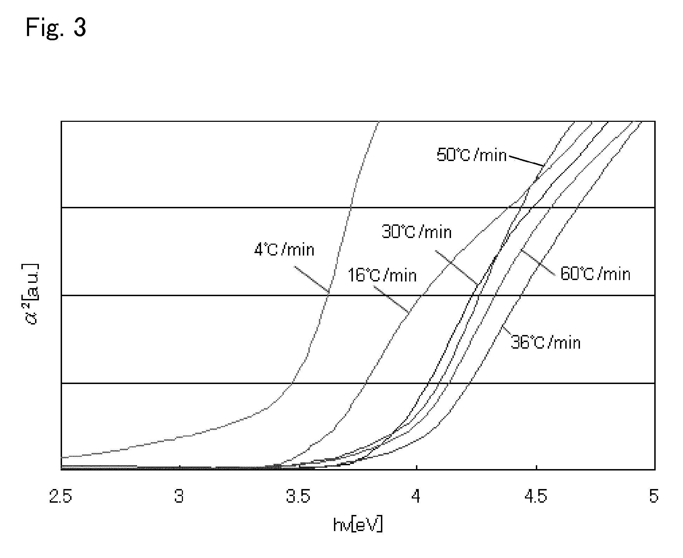

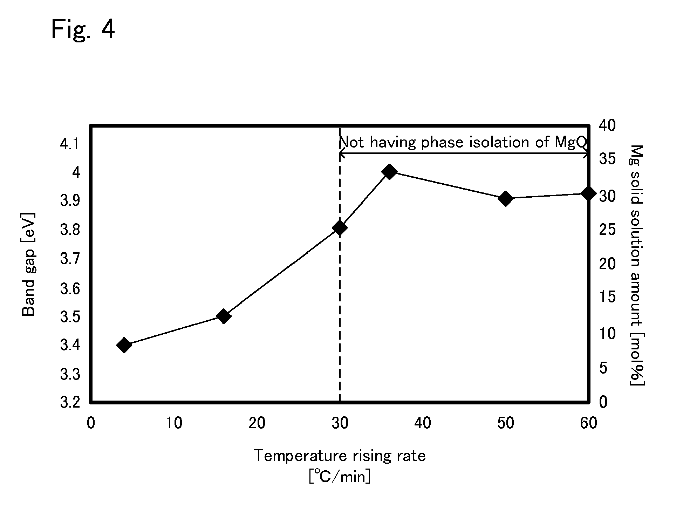

The band gap of the produced film was identified by measuring light absorption coefficient by means of an ultraviolet visible light spectrophotometer (V-570, manufactured by JASCO Corporation). Results are shown in Figs. 3 and 4. In Fig. 3, the square of the light absorption coefficient [a.u.] is taken along the vertical axis, and the energy $h\upsilon$ [eV] is taken along the horizontal axis. The band gap was obtained from the extrapolation line of spectrum. In Fig. 4, the band gap [eV] is taken along the vertical axis on the left side, the Mg solid solution amount [mol%] is taken along the vertical axis on the right side, and the average temperature rising rate [°C/min] is taken along the horizontal axis. The solid solution amount of Mg in Fig. 4 was obtained from the following Formula (1).

```
Mg solid solution amount [mol%] = (band gap-3.2)/0.024 ... (1)
```

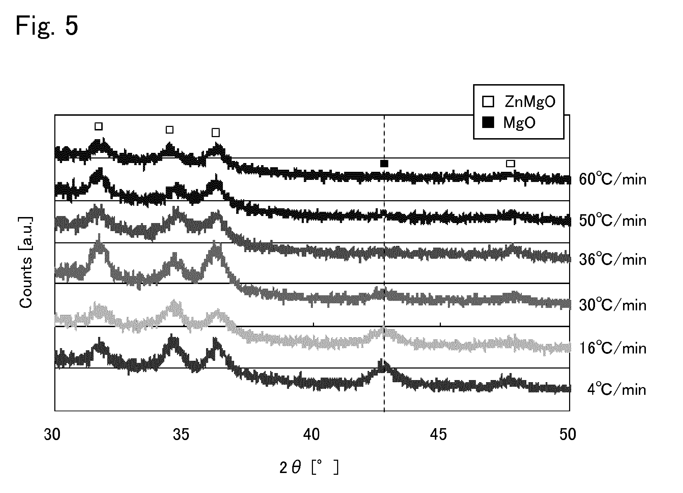

Also, X-diffraction measurement was carried out by means of an X-ray diffraction apparatus (Smart-Lab, manufactured by Rigaku Corporation). Results are shown in Fig. 5. In Fig. 5, Counts [a.u.] is taken along the vertical axis and the diffraction angle $2\theta$ [°] is taken along the horizontal axis. In Fig. 5, "□" indicates the peak originated from ZnMgO and "■" indicates the peak originated from MgO.

<Results>

As shown in Figs. 3 and 4, as the average temperature rising rate from 300°C to 400°C increased, the band gap of the ZnMgO film became wider and the Mg solid solution amount was increased. By having the average temperature rising rate from 300°C to 400°C as 30°C/min or more, it was possible to produce the ZnMgO film having an Mg solid solution amount of 30 mol% or more. Also, by having the average temperature rising rate from 300°C to 400°C as 36°C/min or more, it was possible to produce the ZnMgO film having an Mg solid solution amount of 30 mol% or more.
Also, as shown in Fig. 5, the peak originated from MgO was found out in the precursor film produced with 4°C/min or 16°C/min of the average temperature rising rate in the temperature range from 300°C to 400°C. In contrast, the peak originated from MgO was not found out in the precursor film produced with 30°C/min, 36°C/min, 50°C/min, or 60°C/min of the average temperature rising rate in the temperature range from 300°C to 400°C. From the above results, it was shown that, according to the present invention, a ZnMgO film in which the adding amount of Mg to Zn is more than 20 mol% can be manufactured by means of a liquid phase disposition method.

[Effect evaluation of raw material compounding ratio]

<Manufacturing of film>

Water in an amount of 175 ml and 25 ml of 10% ammonia aqueous solution were put in a beaker. On the other hand, a Zn source (zinc acetate) and an Mg source (magnesium acetate) were weighed so that molar ratios of zinc acetate and magnesium acetate were 9:1, 8:2, 7:3, 6:4, and 1:1. They were put in separate beakers. Then, a rotator was put in each beaker and the contents of the beaker was stirred well on a stirrer to dissolve zinc acetate and magnesium acetate. After dissolving zinc acetate and magnesium acetate, a quarts glass substrate was put in the beaker. Then, while stirring the ammonia aqueous solution, the beaker was bathed in a water bath heated at 60°C and allowed to left for 30 minutes. Thereafter, the quarts glass substrate was taken out and dried at 200°C for 1 hour, whereby a precursor film was produced by means of a CBD method. Next, to the produced precursor film, a conventional heating or a rapid heating was carried out, thereafter the film was fired at 500°C for 1 hour whereby a ZnMgO film was produced. The conventional heating was a heating in which the average temperature rising rate in the temperature range from 300°C to 400°C was 4°C/min and the rapid heating was a heating in which the average temperature rising rate in the temperature range from 300°C to 400°C was 30°C/min, 36°C/min, 50°C/min, or 60°C/min. The ZnMgO film produced by going through the above steps was cooled in a furnace and taken out for evaluation.

<Film Evaluation>

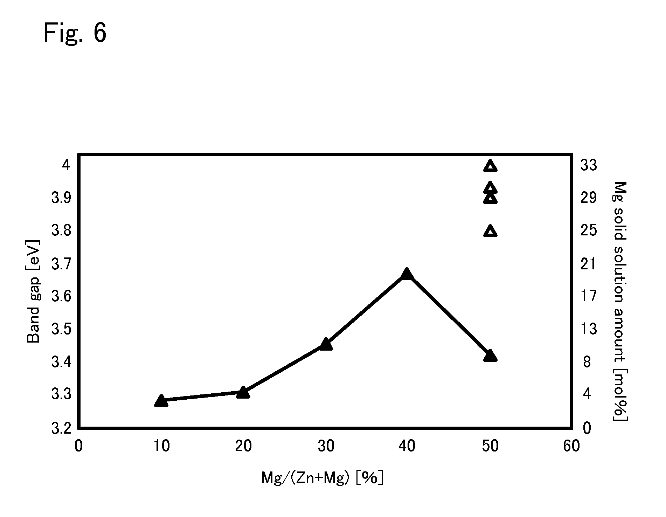

The band gap of the produced film was identified by measuring light absorption coefficient by means of an ultraviolet visible light spectrophotometer (V-570, manufactured by JASCO Corporation). The solid solution amount of Mg was obtained by the following Formula (1). Results are shown in Fig. 6. In Fig. 6, the band gap [eV] is taken along the vertical axis on the left side, the Mg solid solution amount [mol%] is taken along the vertical axis on the right side, and Mg/(Zn+Mg)[%] which is the ratio of the number of moles of Mg source to the sum of the number of moles of Zn source and Mg source included in the raw material is taken along the horizontal axis. In Fig. 6, "▲" indicates the result of samples produced without rapid heating, and "△" indicates the result of samples produced by rapid heating.
As shown in Fig. 6, even without rapid heating, by increasing the molar ratio of the Mg source included in the raw material, the Mg solid solution amount was increased up to 19 mol%. At that time, Mg/(Zn+Mg) was 0.4. However, in a case where the rapid heating was not carried out, when Mg/(Zn+Mg) was increased to 0.5 in order to increase the Mg solid solution amount more than 20 mol%, the Mg solid solution amount was decreased less than 10 mol%. This is because an MgO phase was formed together with a ZnMgO phase. In contrast, by carrying out the rapid heating, even having Mg/(Zn+Mg) as 0.5, the Mg solid solution amount was increased to 25 mol% or more. From the above results, it was shown that, in the manufacturing method of the present invention in which a rapid heating is carried out, it is easy to manufacture the ZnMgO film in which the adding amount of Mg to Zn is more than 20 mol%, by making Mg/(Zn+Mg) larger than 0.4.

**Claims**

1. A method for manufacturing a semiconductor film, the method comprising: a first step of preparing a mixed liquid including zinc hydroxide, magnesium hydroxide, and a liquid; a second step of applying the mixed liquid to a member to be film-deposited; and a third step of heating the member to be film-deposited to which the mixed liquid is applied, having a temperature range from 300°C to 400°C for 100/30 minutes or less.

2. The method according to claim 1, wherein in the third step, the member to be film-deposited to which the mixed liquid is applied is heated with a temperature range from 300°C to 400°C for 100/36 minutes or less.

3. A method for manufacturing a semiconductor film, the method comprising: a first step of preparing a mixed liquid including zinc hydroxide, magnesium hydroxide, and a liquid; a second step of applying the mixed liquid to a member to be film-deposited; and a third step of heating the member to be film-deposited to which the mixed liquid is applied so that an average temperature rising rate from 300°C to 400°C is 30°C/min or more.

4. The method according to claim 3, wherein in the third step, the member to be film-deposited to which the mixed liquid is applied is heated so that the average temperature rising rate from 300°C to 400°C is 36°C/min or more.

5. The method according to any one of claims 1 to 4, wherein a boiling temperature of the liquid is less than 300°C.

6. The method according to any one of claims 1 to 5, wherein determining the amount of Zn included in raw material as X [mol] and the amount of Mg included in the raw material as Y [mol], in the first step, the mixed liquid is produced with the raw material satisfying $Y/(X+Y)>0.4$.

Fig. 1

```
         ┌─────────────┐
         │    START    │
         └──────┬──────┘
                ▼
  S1     ┌─────────────┐
         │ First step  │
         └──────┬──────┘
                ▼
  S2     ┌─────────────┐
         │ Second step │
         └──────┬──────┘
                ▼
  S3     ┌─────────────┐
         │ Third step  │
         └──────┬──────┘
                ▼
  S4     ┌─────────────┐
         │ Firing step │
         └──────┬──────┘
                ▼
         ┌─────────────┐
         │     END     │
         └─────────────┘
```

Fig. 2A

Before rapid
heating

During firing

ZnMgO

After firing

Fig. 2B

Before rapid
heating

During firing

MgO    ZnMgO

After firing

Fig. 3

Fig. 4

Fig. 5

Fig. 6

## INTERNATIONAL SEARCH REPORT

| | International application No. |
|---|---|
| | PCT/JP2013/060905 |

**A. CLASSIFICATION OF SUBJECT MATTER**
*H01L21/368*(2006.01)i, *C01G9/00*(2006.01)i, *H01L21/20*(2006.01)i, *H01L31/04* (2006.01)i

According to International Patent Classification (IPC) or to both national classification and IPC

**B. FIELDS SEARCHED**

Minimum documentation searched (classification system followed by classification symbols)
H01L21/368, C01G9/00, H01L21/20, H01L31/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)
JSTPlus(JDreamIII)

**C. DOCUMENTS CONSIDERED TO BE RELEVANT**

| Category* | Citation of document, with indication, where appropriate, of the relevant passages | Relevant to claim No. |
|---|---|---|
| A | JP 2010-129641 A  (Kyocera Corp.), 10 June 2010 (10.06.2010), paragraphs [0021] to [0050]; fig. 2 (Family: none) | 1-6 |
| A | JP 2008-230878 A  (Mitsubishi Materials Corp.), 02 October 2008 (02.10.2008), paragraphs [0022] to [0034] (Family: none) | 1-6 |
| A | WO 2008/114845 A1  (Mitsubishi Gas Chemical Co., Inc.), 25 September 2008 (25.09.2008), page 10, line 19 to page 11, line 25 & EP 2135978 A1      & CN 101688325 A & KR 10-2010-0015670 A   & TW 200848556 A | 1-6 |

☐ Further documents are listed in the continuation of Box C.     ☐ See patent family annex.

| | |
|---|---|
| * Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| 30 May, 2013 (30.05.13) | 25 June, 2013 (25.06.13) |

| Name and mailing address of the ISA/ <br> Japanese Patent Office | Authorized officer |
|---|---|
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004304175 A

**Non-patent literature cited in the description**

- *Nanotechnology,* 2011, vol. 22 (42), 425706